# EUROPEAN PATENT SPECIFICATION

(11) **EP 3 175 761 B1**
(45) Date of publication and mention of the grant of the patent: **29.08.2018**
(21) Application number: 15197537.2
(22) Date of filing: 02.12.2015
(51) Int. Cl.: A47L 15/00, G01R 31/02, D06F 37/42, D06F 33/02, A47L 15/42, D06F 39/04

(54) **METHOD FOR DETECTING A FAULT IN AN INSTALLED APPLIANCE**
VERFAHREN ZUR DETEKTION EINES FEHLERS IN EINEM INSTALLIERTEN GERÄT
PROCÉDÉ POUR DÉTECTER UN DÉFAUT DANS UN APPAREIL INSTALLÉ

(43) Date of publication of application: 07.06.2017
(73) Proprietor: Whirlpool Corporation, Benton Harbor, MI 49022 (US)
(72) Inventor: Thumm-Jorge, Margret, 21025 Comerio (IT); Poettger, Robert, 21025 Comerio (IT)
(74) Representative: Spina, Alessandro

(56) References cited:
- EP-A1- 2 353 485
- EP-A1- 2 840 404
- EP-A2- 0 924 331
- WO-A2-2014/155336

## Description

The present invention relates to an improved method for detecting faults in an installed appliance using water, especially a domestic appliance.

Diagnostic methods for checking the correct behaviour of electrical appliances are already known in the art. In this regard EP-A-00924331 and EP-A-2353485 describe diagnostic methods applicable to appliances supplied with water, in particular washing machines, dishwashers or the like.

A drawback of these known diagnostic methods stands in that they can be correctly executed only if the appliance is electrically connected to ground/earth in a proper manner, that is, according to the standard regulations effective in the most modern countries. However, in situations where this electrical connection is not sufficient or it is interrupted, critical safety issues could be faced by the user. In particular, a risk of an electrical shock could exist whenever a metallic portion of the chassis which can enter in contact with the user, becomes at the potential of the mains. This occurrence could be caused by a fault internal to the appliance, for instance whenever an internal wiring carrying the power supply is interrupted (for instance when it becomes disconnected, broken or cut) and enters in contact with a metallic part of the appliance. The same risk could also occurs when an internal electric or electronic component, for instance a heater or a pump motor, loses its electric insulation towards the metallic support to which is fixed, and whenever the same support is or becomes in electric contact with the metallic chassis (cabinet) of the appliance. The latter occurrence is hidden to the user and can be caused by aging or tear of the component and it can happen especially when the component gets in contact with water.

Risk of an electric shock for the user can become higher whenever safety devices are not installed in the household power supply network, if he/she touches said metallic portion of the chassis and the at the same time a water tap.

At present there are no convenient solutions that can be easily integrated into an appliance and which are capable to detect an installation in which a ground/earth connection is missing or is deteriorated, so preventing or mitigating risky consequences for the user, especially in appliances operating with water like washing machines or dishwashers.

Aim of the present invention is therefore to provide a method for detecting a fault in an electric appliance into which water is supplied or drained and which overcomes the drawbacks of the known solutions.

These results are achieved by the present invention thanks to the characteristics listed in the accompanying claims.

Further characteristics and advantages of the present method will become apparent from the following description of preferred embodiments, taken in conjunction with the drawings, in which:
- Figure 1 is a schematic representation of an appliance according to the present invention into which water can be supplied or drained;
- Figure 2 represents the flow chart diagram describing the steps for detecting a defect of an electric/electronic component and/or a not properly grounded appliance.

In a first aspect, the method of the present invention is applicable to detect insulation faults of one or more electric or electronic components such as heaters, motors, sensors, pressostats or the like, in appliances in which a resistive path over the water can be created.

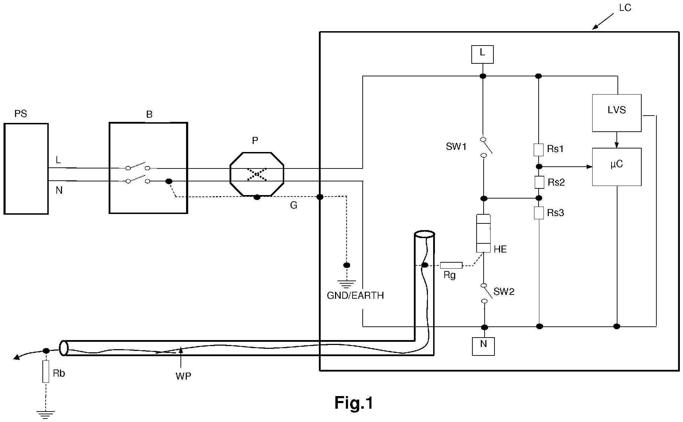

With reference to Fig. 1 it is generically described the electric connection of an appliance operating with the use of water, particularly a domestic appliance, to the power supply network, comprising an electric or electronic component to be monitored (the component of interest). The schematic represents one of the possible configurations of an appliance in regard to which the disclosed method of the present invention can be applied.

Even though the schematic of the appliance of Fig.1 is particularly related to a washer or a dishwasher, the method of the present invention is not restricted to said configuration or limited to said appliances since it can be also applied to similar appliances such as humidifiers, air ionizers, air conditioners, steamers, ironing systems, coffee machines, dryers, steamers, kettles, boilers.

In the described embodiment, the appliance operating with the use of water is electrically supplied with the mains voltage generated by a power supply plant PS and furnished through the power supply network. The power supply network typically comprises at least two conductors named line conductor L and neutral conductor N. However, a three phases supply line is however compatible with the present invention. Normally, the neutral conductor N represents the reference voltage based on which the voltage of the line conductor L varies. Voltage from the mains is properly scaled to 110-210-240 Volts (at 50 or 60 Hz) for supplying household appliances. Electric current breakers B for intercepting the mains are normally positioned upstream the household appliance in the electric power network. According to the most recent regulations each household electric plant has also to be provided with a ground connection to which the ground electrode and/or the earth electrode of appliances are to be connected. The ground connection consists of an (ground/earth) electrode G electrically connected to ground GND through a resistive path of about 0 Ohm. Typically, the ground electrode G and the neutral electrode N are connected together just after the breaker of the household network (as shown in Fig 1). However, this is not relevant for the method of the present invention, even though a connection to ground of the appliance is expected and recommended.

In the household power supply network an appliance can be directly connected to the Line L, Neutral N and ground G conductors with the harness or trough a plug P, as for instance shown in Fig. 1.

An appliance typically comprises electric components that need to be supplied directly with the electric power of the mains as for instance heating elements, pumps, motors, thermostats, lamps, electro-valves other actuators etc..

An appliance may also comprise other electronic components and/or electronic circuits that need to be supplied with a low voltage source LVS circuit, such as sensors, the monitoring (logic) circuit LC, and the control circuit of the appliance. The low voltage source LVS circuit, which is typically a voltage adapter or a voltage transformer, is normally internal to the appliance and connected to the line L and neutral N conductors for the supply of electric current.

In the embodiment of Fig. 1, the monitoring logic circuit LC and the control circuit are shown as integrated into the complete system, even if the same functionality can be split in two or more separate components or circuits, including analog circuits.

The method of present invention can be applied to appliances provided with electric or electronic components which can enter in direct contact with water supplied into the appliance and/or drained from it. In fact, whenever water, preferably a stream WP of flowing water, enters in contact with a component which presents a reduced or even a lost electrical insulation resistance Rg to ground GND or earth, said water creates an electric (high) resistive path R_{water}, causing an electric current to be dispersed through the same water. Such electric or electronic components are for instance motors, electric heaters, thermostats, lamps, probes, pressostats and sensors.

However, the method of the present invention can be also applied to appliances in which said electric or electronic components are not in direct contact with water but for which an electric conductive (high resistive) path R_{water} towards ground/earth GND can be established via internal parts when such parts enter in contact with water, in particular with a flowing water path WP (a water stream) in input to or in output from the appliance. Such internal parts are for instance the grounding harness, the component support or any other grounded component in electrical connection with said component (i.e. the sump heater, the drum, the pressostat..).

According to the present invention, water can be introduced into the appliance from the (household) water supply network, through air condensation, or by a manual filling of the water tank. In an advantageous embodiment the water reservoir/container (or at least one of its portion) can be electrically connected to ground/earth through harness. In a similar manner, water can be drained from the appliance by means of discharge tube, in a manual or automated manner, or even exploiting water evaporation. The water filling and/or draining system can be part of a more complex hydraulic system which can be also provided with controlled valves and/or hydraulic pumps. According to the present invention, in such hydraulic system water pipe(s) can be made either of insulating materials, for instance plastic, or of conductive material (for instance metal) since their conductivity is not exploited by the method of the present invention. In fact, the method of the present invention exploits the conductivity of not distilled water, preferably flowing water WP, for detecting an electric failure of an electric or electronic component belonging to the appliance and/or for diagnosing when the electrical connection ground of the appliance to ground/earth GND is deteriorated or is missing. This allows detecting whenever an appliance is not properly installed and/or to detect a component failure even when the ground connection is discontinued or is missing.

The above results can be achieved by an electric conductive path R_{water} through water, preferably created on a temporarily basis, preferably towards ground GND or earth. The method of the present invention requires measurements and/or estimations of the resistance R between said electric or electronic component (the monitored component, also hereafter referred as the component of interest) and ground GND and/or earth in different operating conditions of the same component and/or of the appliance. The determined/estimated resistance R to ground GND and/or earth is then compared with some predetermined (electrical) thresholds values linked to expected values of the insulation resistance Rg of the same electric or electronic component for the corresponding operating condition.

Said measurements/estimations preferably involve one or more sampled electrical parameters of the electric circuit directly or indirectly related to the monitored component. Measurements/estimations may include further computational steps, including any parametric estimation made through the monitoring/logic circuit LC and/or through the control circuit uC.

In the advantageous embodiment of the present invention described in Fig. 1, the component to be monitored is a resistive heating element HE. Its insulation resistance Rg is monitored through the logic circuit LC (and/or the control circuit uC) in order to check if it becomes sufficiently low (in the order of 100 kOhm or lower) for being inefficient and/or potentially harmful for a user. The monitoring activity can be performed continuously, at predetermined time intervals, or at predetermined operational steps of the appliance, when water is introduced into the appliance or when drained from it. Preferably, the monitoring activity is performed at the start or at the beginning of a wash cycle.

The resistive heater HE is typically positioned in a lower position within the wash tub. During normal operation, the resistor HE is consistently not activated before being covered by or immersed in water in order to prevent the overheating of the tub ("a dry activation").

The appliance of Fig. 1 could include a system of optional switches SW1 and SW2 which can be operated by the logic circuit LC and/or by the control circuit uC. Said switches are preferably used for preventing a "dry activation" and for performing a selective diagnostic of at least one electric and/or electronic component. This functionality is for instance described in EP-A-00924331 or in EP-A-2353485 in regard to the heating element HE and/or of the pump motor. In commercial appliances, switches SW1 and SW2 can also be operated by means of a pressostat-switches driven by the water fed into or drained from the appliance tab.

The same above cited documents describe in detail a monitoring circuit LC, which is at least a logic circuit and which can be used for monitoring at least one electrical or electronic component for the purposes of the present invention, as previously described. The monitoring circuit LC (and/or the control circuit uC) of Fig. 1 is configured for monitoring a fault of the electric heater HE by determining/estimating its resistance R towards ground/earth GND through the sampling one or more electrical parameters. The circuit connecting the monitored component HE to the logic circuit LC could advantageously comprise a resistive partition Rs1, Rs2, Rs3 to scale and conditioning the sampled signal to be processed by the logic circuit LC (and/or the control circuit). The resistance to ground GND earth is measures/estimated by logic circuit LC through the sampled electric parameters linked with the monitored component. For details concerning the configuration and the description of said monitoring circuit and for the estimation/calculation of the resistance to ground GND or earth, it is here intended to refer to the previous mentioned applications.

The measured/estimated resistance R to ground GND or earth of the monitored component HE, is then used by the logic circuit LC and/or the control circuit uC to identify the occurrence of a fault of the same component or of the appliance, in dependence to parameters linked with insulation resistance Rg expected for the monitored component.

It is here pointed out that the insulation resistance Rg of a new manufactured water heater HE, is typically very high (>100 MOhm) and has no influence to the operations and to the safety of the appliance while, in an old or faulty heater HE, the insulation resistance Rg may become so small that leakage current becomes significant and risky for the user.

Above a certain level of the leakage current flowing through the insulation resistance Rg, the electric or electronic component (the heater HE) has to be replaced, because becomes "faulty", since a too high leakage current can cause dry heat, burnout or other safety issues, as before described.

According to a first aspect of the present invention it is disclosed a method for identifying when a monitored component is faulty or when it presents at least a reduced insulation to ground GND or earth before to become critical, i.e. before to become faulty, even in the case when the connection to ground GND or earth is missing or deteriorated.

In the described example, it is detected when the electric resistor HE is not operating within acceptable working conditions (is therefore "deteriorated") by evaluating (meaning by measuring directly or by estimating) its resistance R to ground GND and/or earth. According to the present invention this detection is made possible by the creation of an electrical conductive path (R_{water}) through water, preferably having a predetermined duration. This can be done by introducing water into the appliance or by draining water from the appliance.

According to the present invention, the monitored component can be characterized through the status of one or more of its parameters linked with its insulation resistance Rg performances. In the described (non limitative) example, the status of the heater HE can be advantageous characterized through its operating temperature (either the surface temperature of the component, the surrounding temperature, the internal temperature or any temperature correlated with said component, etc..). In other embodiments, additional or alternative parameters, such as humidity, pressure, radiation emissions, age of the component, electrical parameters (for instance the average/peak power delivered) and mechanical parameters (deformation..) can be considered, alone or in combination, for defining the proper status of the monitored component.

According to a first aspect of the present invention, and referring to the embodiment of Fig. 1, the monitored component (the heater HE) is initially taken or maintained in substantially stable first operating conditions: conditions under which the status of one or more parameter/s characterizing the status of the component is/are at/within a first predetermined value/s or range of values.

In said first operating conditions, during a first step of the method, a first resistance R1 to ground GND or earth of the electric or electronic component (of interest) is measured or estimated in a known manner, as for instance described in the aforementioned applications.

In a second step of the method, water is fed into or drained from the appliance to fill/empty the tub or the reservoir, even for a limited time period. According to the invention water introduced into the appliance or drained from the appliance, preferably a stream of flowing water WP, creates (directly or indirectly) an electrically conductive (high resistive) path R_{water}, between the monitored component and ground GND or earth potential, acting as a conductor, preferably as a temporary conductor. In fact, the high resistive path over water R_{water} enables the passage of an electric (leakage) current, especially when the monitored electrical/electronic component is electrically supplied and when the same component presents a reduced (or even lost) electrical insulation Rg towards ground GND or earth. Circulation of electric current in the created water path R_{water} can occur whenever the heater HE is supplied to at least one of its terminals, in particular when supplied with the line conductor L. It is here pointed out that according to the present invention the component of interest HE can be supplied in a voluntary way (e.g. driven by means of switches SW1 and/or SW2), or in involuntary manner (e.g. as a consequence of a fault, especially a permanent fault). In both cases the method of the present invention can be applied. Preferably, the circulation of electric current in the component of interest is driven in a controlled manner, for instance trough switches SW1 SW2, when the high resistive path R_{water} over water is present or is created, for the purposes of measuring or estimating the resistance R to ground GND earth. Depending on the component to be monitored, the resistive path R_{water} is preferably a temporary path. However the resistive path R_{water} can also be persistent with the water present in the appliance reservoir. The latter case could occur when the monitored component, or the appliance, is in a permanent fault condition e.g. when the heater HE is permanently supplied in short circuit. This is especially applicable when the heater HE is placed into a tab/reservoir connected to ground GND earth and enters in contact with water, particularly when it is submerged within water. Therefore, a controlled electric supply of the monitored component HE is not always necessary for the purposes of monitoring the same component, and in particular for measuring or estimating the resistance R to ground GND or earth.

In case when a temporary resistive path R_{water} is created in a driven manner, its duration preferably depends on the time during which water flows in or out of the appliance, but it can be also have a different predetermined (even reduced), duration. This predetermined (time period) duration can be set either in a manual or in automated manner, preferably through the activation of the components belonging to the hydraulic circuit (pumps, valves...). In a preferred embodiment the temporary (high) electrical resistive path R_{water} over water is created between the monitored component and ground GND or earth either, when water flows into the appliance (fed water) and/or also when water is drained from the appliance.

Preferably, the temporary high resistive path is created and maintained for a predetermined time period in the range from some milliseconds to some minutes, preferably less than a minute, and more preferably about some seconds in order to make reliable measurement(s) of the electric parameters required for obtaining the resistance R to ground GND or earth. Advantageously, in the described machine of Fig. 1 the (high) resistive path R_{water} is created for the above purposes when the monitored component is substantially stable in said first operating conditions, preferably when the wash tub is filled during the execution of the wash program, or when it is emptied for the purpose of rinsing, or when water is drained, in particular before to starting the spin cycle. In these first operating conditions the (high) resistive path R_{water} is preferably created by the actuation of a hydraulic valve, optionally in combination with a pump, which allows water to flow into the appliance, or allows water to be drained.

When the resistive path R_{water} (over water) is created, the monitoring circuit LC (and/or the control circuit uC) executes the sampling of one or more electrical parameters of the component of interest which is preferably electrically supplied in a controlled manner. In this second step the resistance R2 to ground GND or earth of the component is newly measured or estimated in a known manner.

By using the measured or estimated the resistance R to ground GND in said first operating conditions during the first and the second steps (i.e. before and/or after and/or during the time when the temporary high resistive path R_{water} over water path is created), the monitoring circuit LC can further carry out the diagnostics of the monitored component, in particular the diagnostic of the heating resistor HE of the washing/dishwashing machine of Fig. 1.

It is here pointed out that the value of the resistive path over water R_{water} to ground GND or earth is higher than the resistive path normally requested by the norms for the ground connector G. Therefore it cannot be used as an alternative to a ground/earth connection under the meaning of the norm.

The inventors have discovered that the value of the resistive path over the water R_{water} is comparable with resistive paths of other appliance internal components, e.g. grounding harness, belt, bleeding resistor, tubes and hoses, which can in principle be used for the same purposes. The resistances of this resistive path R_{water} is in the range from some Mega Ohms up to Giga Ohms, depending on the technology adopted for the component.

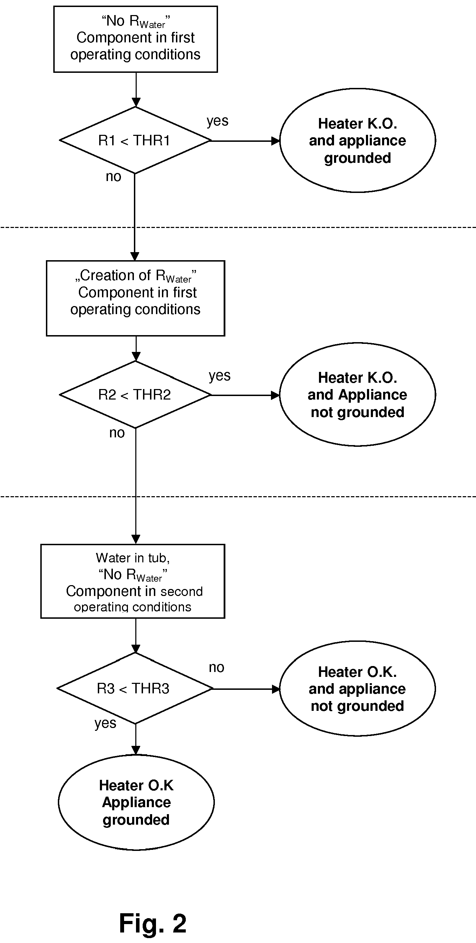

More in detail, a direct or an indirect comparison (though predetermined thresholds values) of the first resistance R1 to (the potential of) ground GND or earth, measured/estimated during the first step of the method, with the second resistance R2 to the potential of ground GND or earth, measured/estimated during the second step of the method (during which a resistive path R_{water} over water, preferably a temporarily resistive path, is created), allows diagnosing a wrong behaviour of the monitored component. This will be further described more in detail in regard to one of the possible use of the method of the present invention, particularly for detecting a fault in an installed water operated appliance, and also for detecting whether an appliance is correctly installed through the identification of a missing connection to ground GND or earth. This advantageous use of the present invention is following described by way of a non limiting example with reference to Fig. 2 (described in regard to the appliance of Fig. 1).

The method of the present invention, is advantageously applied for obtaining a method for detecting a fault in an installed water-operated appliance. According to said use of the method, during a first phase it is assumed that the appliance is properly connected to ground GND or earth. That means that the appliance is assumed as correctly installed.

According to the above, during a first step of said first phase of the method the electric or electronic component of interest is brought to or maintained into substantially stable first operating conditions.

During said first phase, when the monitored component is at an initial first predetermined temperature, it is checked whether the estimated or measured value of the first resistance R1 to ground GND of the heating element HE (the monitored component) the appliance of Fig. 1, is substantially lower than the insulation resistance Rg of a heating element HE which is in good working condition. In other words, it is checked whether the electric or electronic component (the heater HE) is not working properly when assuming that the appliance properly installed, that is, if it is properly connected to ground GND or earth.

In a preferred embodiment it has been advantageously selected that first operating conditions for the appliance of Fig. 1 are the ones in which the heater HE is initially shut off (substantially in rest conditions/status). Accordingly, its first predetermined temperature is the initial room/ambient temperature. However, it is here remarked than any other temperature of the monitored component can be used for the same purpose.

When said first operating conditions are substantially stable, measurements of one or more electric parameters according to the present invention are taken by the monitoring circuit LC in regard to the monitored component.

In particular, during said first phase of said first step voltage/current signal(s) is/are sampled from the monitored component, e.g. heating element HE, preferably as described in EP-A-00924331 or in EP-A-2353485. For this purpose, the heater HE can be temporary supplied by closing one or more switch contact(s) under the supervision of the logic circuit LC and/or of the control circuit uC, or by the movement pressostat switches, before and/or during executing of the sampling. Sampled signal(s) are then optionally processed in order to determine or to estimate a value of the first resistance R1 to ground GND. For these purposes we also refer to sections of the applications EP-A-00924331 or EP-A-2353485, in which examples of estimations of the resistance R to ground GND (therein named as Rg) are disclosed.

Afterwards, the first resistance R1 to ground GND is compared with a first resistance threshold THR1 in order to check for a defect of the electric or electronic component of interest. The first resistance threshold THR1 is selected in a range of values for which the insulating resistance Rg of the monitored component can be considered at the lower limit of its operational specifications.

For this reason THR1 can be in the range from 1Ohm to any measureable value (some GOhm), depending on the component type and on the technology applied thereto. For the heater HE of the described embodiment, THR1 can be optimally set in the range from around 30 kOhm up to more than 10 MOhm, preferably from 30 kOhm up to 5 MOhm, more preferably about 70 kOhm, which is the insulation resistance value necessary with a supply of 230V to prevent a leakage of electric current of 3,5 m Amp. However this value of the first resistance threshold THR1 is indicative, and can be therefore different since it depends on the electric/electronic monitored component, from the power supply voltage and also on the precision of the measuring circuit LC. Moreover, the threshold THR1 can be also compensated in dependence of the effective value of the supply voltage, as explained in details in the referenced applications, particularly in presence of voltage variations.

If from the comparison it is ascertained that the first resistance R1 to ground GND is lower than the first resistance threshold THR1, it is possible to conclude that the monitored component (the heater HE) has a reduced insulation resistance R to ground GND or earth, and that the component is faulty. The user can be notified with an acoustic and/or visual indication, and where needed, the component should be replaced. In case the first resistance R1 to ground results higher than THR1, it cannot be concluded that the component is working properly since this results may also be due to a missing or deteriorated connection to ground/earth. To further discriminate on this point the method according to the present invention is provided with a further additional second step.

In a second further step according to the method are performed checks to verify whether the appliance is not correctly connected to ground or earth GND (meaning to check if the appliance is not correctly installed) and checks to verify if the electric or electronic component (of interest) has at least reduced performances, meaning that a second resistance R2 to ground GND linked with the insulation resistance Rg of the monitored component is still in the operative range, but close to be out of order, or faulty (particularly in short circuit).

More in detail, while the heater HE (the monitored component) is substantially maintained in first operating conditions (i.e. at a first initial temperature) a high resistive path over water R_{water} is created for instance by opening the inlet hydraulic valve for the filling of the tub, causing water to flow into the tub. Alternatively, water can be fed into the appliance by the actuation of a pump. Preferably, the resistive path over water R_{water} is created for a predetermined time period.

During second step, voltage/current signal(s) is/are newly sampled from the in a usual manner. The monitored component is optionally electrically supplied during said phase, depending on the configuration of the appliance.

A second resistance R2 to ground GND is determined or estimated, as in the first step. Further, the second determined or estimated resistance R2 to ground GND is compared with a second resistance threshold THR2.

The value of said second resistance threshold THR2 is a resistive threshold value within the same range of THR1, which is established by taking into consideration the additional value of the temporary high resistive path created over water R_{water}, indicated Rb in Fig. 1. THR2 is therefore in the range from few Ohms to several Mega Ohm, depending on the conductivity of the water fed in said appliance (eventually measured or estimated by the logic circuit LC in an usual manner) and on the conductivity of the water pipes. For these reasons the method could further include a preliminary step of measuring or estimating the conductivity of the system in presence of water, preferably of flowing water. This optional step preferably includes a direct measurement of the conductivity of the same water, preferably by using sensors.

In the described case THR2 is optimally in the range between 2 MOhm and 20 MOhm, and is preferably set about 5 MOhm. However this value of the second resistance threshold THR2 is indicative, and can be therefore different since it depends on the electric/electronic monitored component (the heater HE in the described case) and also on the precision of the measuring circuit LC. The second resistance threshold value THR2 can be also compensated in dependence of the effective value of the supply voltage, in presence of voltage variations, as explained for the first step.

If from the comparison it is ascertained that the second determined or estimated resistance R2 to ground GND is lower than the second resistance threshold THR2, it is possible to conclude that the appliance is not properly connected to ground GND or earth and that the insulation resistance Rg of the monitored component (the heater HE) is at least deteriorated or that the heater HE is faulty. The users can be notified with an acoustic and/or visual indication. The appliance has to be disconnected from the power supply network. The ground GND or earth installation and appliance heater need to be repaired.

In case the second resistance R2 to ground results higher than THR2, it cannot be concluded that the component is working properly and that the appliance is properly connected to ground GND earth. In fact, this results can also be achieve whenever the heater HE is working properly but the appliance is not properly connected to ground GND or earth. To further discriminate on this point the method according to the present invention is provided with further additional third step.

According to the method, in a third step, it is verified whether, as expected, the electrical insulation resistance Rg of the electric or electronic component (the heater HE) changes when the operating conditions of the same component are significantly changed. In fact, the electrical insulation resistance Rg of an electric or electronic component and therefore the leakage of electric current can be substantially different under different environmental and/or operational conditions, in which parameters such as the power supplied to the component, the temperature of the component, humidity, pressure or others parameters are changed. For this reason the described first and second operating conditions can be by characterized, for instance by the operating temperature, pressure, humidity, and mechanical properties of the component of interest. These parameters can be considered separately or in combination when characterizing the operating conditions for the component of interest. They can vary, depending on the age and use of the component.

The latter verification, performed after the second step of the method, in which it has been ascertained that the insulation resistance Rg of the heater HE is within the operational parameters range, will allow ascertaining if the appliance is properly connected to ground GND or earth.

Before to start the third step in which the component (heater HE) is switched to second operating conditions, water present in the tub with the previous step has to be preferably drained.

As an alternative, in the described embodiment water introduced in the previous step covering or submerging the heater HE can be maintained to prevent overheating, preferably if such water does not create the high resistive path over water R_{water}. Accordingly, in the third step the status of the monitored component, the heater HE in the described embodiment, is switched to second operating conditions (either in a quick manner or after a certain time transient), conditions in which the electrical insulation resistance Rg of the electric or electronic component is expected to be significantly changed.

According to the described embodiment, preferred second operating conditions are the ones in which the temperature of the monitored component (electric resistor HE) is at second predetermined temperature, a temperature which is substantially different (higher or lower) than the first temperature which corresponds to the temperature of the same component in first operating conditions.

Modification of the operating conditions can be achieved through the energization of the same component. When the monitored component (the heater HE) is in second operating conditions, its insulation resistance Rg is expected to decrease in normal operating conditions (not when a failure is present). At physical level, the internal insulation material (e.g. MgO) of the heater HE, which is a temperature related material, should in fact reduce the insulating resistance Rg of the heater HE, when the temperature increases.

When said second operating conditions are substantially stable, measurements of one or more electric parameters according to the present invention are taken by the monitoring circuit LC in regard to the monitored component, as in any of the previous steps. A third resistance R3 to ground GND is further determined or estimated as in the first or in the second step.

Afterwards, the third determined or estimated resistance R3 to ground GND is compared with a third resistance threshold value THR3. Said third resistance threshold value THR3 is linked to the resistance characteristics of the insulation material of the monitored component under second operation conditions and can be lower, equal or higher that THR1.

THR3 is selected in a range of values for which the insulating resistance Rg of the monitored component can be considered within the lower limit of its operational specifications, taking also into consideration the expected reduction of the insulation resistance Rg when the component is within acceptable operational working conditions.

For the described embodiment THR3 is preferably set higher than THR1. Optimally, as for the described case, THR3 in the range between 100 kOhm and 1 MOhm, preferably about 300 kOhm.

However this value of the third resistance threshold THR3 is indicative, and can be therefore different since it depends on the electric/electronic monitored component (the heater HE in the described case), on the insulation resistance drift of the monitored component, from the supply voltage of the component while being active (e.g. temperature related resistance of insulation material) and also on the precision of the measuring circuit LC. The second resistance threshold value THR3 can be also compensated in dependence of the effective value of the supply voltage, in presence of voltage variations, as explained for the previous steps.

If it can be assessed that the third determined or estimated resistance R3 to ground GND is greater than the third resistance threshold THR3, it is possible to conclude that the connection to ground/earth GND is at least deteriorated, and more probably missing. It is so possible to conclude that the heater HE is still working properly while the appliance is not properly installed. The user can be notified with an acoustic and/or visual indication. The appliance has to be disconnected from the power supply network. The ground installation and appliance heater need to be repaired.

In the opposite case in which the third calculated or estimated resistance R3 to ground GND is lower than the third resistance threshold THR3, it is possible to conclude that the monitored component, e.g. heater HE, is working properly and that the appliance is properly connected to ground GND. The appliance can continue its operations in a normal manner.

Preferably THR1, THR2 and THR3 are static values determined for the type of appliance prior to execute the present method and stored in a memory. Dynamic thresholds can be also calculated in dependence of the actual/normal conditions, eventually using conductibility sensors.

It is here underlined that the given threshold values THR1, THR2 and THR3 are purely indicative since they are referred to the configuration of the washing machines Whirlpool SCW 1112 WH supplied at 230V and Whirlpool WFW 9100 SQ00 supplied at 120V, both the machines being currently in production. A different set of threshold values can be established for a different construction/circuit of the appliance.

It has been therefore disclosed an improved method which allows detecting faults in an installed appliance into which water can be fed for operating the appliance.

Even if a preferred embodiment has been described in the above, any possible further combination with any alternative or optional features/steps above described, still remains within the scope of the present invention.

## Claims

1. Method for detecting a fault in an installed water operated appliance, preferably a washing machine or a dishwasher, comprising the steps of
- determining or estimating a first resistance (R1) to ground (GND) of an electric or electronic component (HE) in first operating conditions;
- comparing the determined or estimated first resistance (R1) to ground (GND) with a first predetermined resistance threshold (THR1), in order to check for a defect of the electric or electronic component (HE),
**characterised in that** the method further comprises the steps of:
- creating a temporary electrically conductive path (R_{water}) through water;
- determining or estimating a second resistance (R2) to ground (GND) of said electric or electronic component when such temporary electrically conductive path (R_{water}) through water has been created in said first operating conditions;
- comparing the said determined or estimated second resistance (R2) to ground (GND) with a second predetermined resistance threshold (THR2), in order to check for a defect of the electric or electronic component (HE) when an electrical connection to earth or to ground (GND) is missing or deteriorated.

2. Method according to claim 1 further comprising the steps of:
- switching said electric or electronic component (HE) from said first operating conditions to second operating conditions;
- determining or estimating a third resistance (R3) to ground (GND) of said electric or electronic component (HE) in said second operating condition;
- comparing the said determined or estimated third resistance (R3) to ground (GND) with a third predetermined resistance threshold (THR3) in order to assess whether there is a missing or deteriorated electrical connection to earth or to ground (GND) of the water operated appliance.

3. Method according to claim 1 or 2 in which the steps of determining or estimating said first resistance (R1) to ground (GND), said second resistance (R2) to ground (GND) or said third resistance (R3) to ground (GND) of said electric or electronic component (HE), further include the step of sampling one or more voltage/current signals from said electric or electronic component and the step of processing said one or more voltage/current sampled signals in order to determine or to estimate an insulation resistance (Rg) of said electric or electronic component (HE).

4. Method according to any of the preceding claims in which said electric or electronic component (HE) is electrically supplied by closing one or more switch contacts (SW1, SW2) by a logic circuit (LC) and/or of a control circuit before determining or estimating at least one of said first, second or third resistance (R3) to ground (GND) of said electric or electronic component (HE).

5. Method according to any of the preceding claims, in which said electric or electronic component (HE) is controlled by the logic circuit (LC) in order to be electrically supplied before and/or during executing the sampling.

6. Method according to any of the preceding claims in which said first predetermined resistance threshold (THR1) is in a range of values for which the insulating resistance of the electric or electronic component (HE) can be considered out of it operational specification, said insulating resistance being preferably in the range from 1 Ohm to 10 GOhm, optimally in the range from around 30 kOhm, up to more than 10 MOhm, and more preferably around 70 kOhm.

7. Method according to any of the preceding claims in which said second predetermined resistance threshold THR2 takes in to account a resistive path over water (R_{water}) and is in a range of values from 1 Ohm up to 10 GOhm, optimally in the range from 2M Ohm to 20 MOhm, and preferably about 5 MOhm.

8. Method according to any of the preceding claims in which said third predetermined resistance threshold THR3 is optimally in the range between 100 kOhm and 1M Ohm, preferably about 300 kOhm.

9. Method according to any of the preceding claims wherein said first operating conditions and said second operating conditions of said electric or electronic component (HE) are defined in such a way that insulation properties of said electric or electronic component, in particular an insulation resistance (Rg) thereof, are substantially different.

10. Method according to any of the preceding claims wherein a first operating temperature of said electric or electronic component (HE) in said first operating conditions is substantially different from a second operating temperature of said electric or electronic component (HE) in said second operating conditions.

11. Method according to any of the preceding claims, wherein said switching of said electric or electronic component (HE) from said first operating conditions to said second operating conditions is obtained through an energization step of said electric or electronic component (HE).

12. Method according to claim 10, wherein said first operating temperature of said electric or electronic component (HE) in said first operating condition is lower than said second operating temperature of said electric or electronic component (HE) in said second operating conditions.

13. Method according to any of the preceding claims wherein said temporary resistive path (R_{water}) is created by flowing a water stream (WP) into said appliance or by draining water from said appliance, preferably through automatic actuation of a hydraulic valve and/or through the actuation of a pump.

14. Method according to any of the preceding claims wherein, when a failure is detected, the appliance notifies said failure to a user with a visual and/or with an acoustic signal.

15. Appliance operating with water, preferably a domestic appliance operating with water, provided with: a logic circuit (LC) and/or with a control circuit for the detection of a fault, an electric or electronic component (HE) which can enter in an electric conductive path to ground (GND) and/or earth due to the presence of water in the appliance, **characterized in that** the appliance is configured to implement a method according to any of the preceding claims.

## Patentansprüche

1. Verfahren zum Detektieren eines Fehlers in einer installierten wasserbetriebenen Vorrichtung, vorzugsweise einer Waschmaschine oder einer Spülmaschine, umfassend die Schritte des
- Bestimmens oder Schätzens eines ersten Erdungs- (GND) -widerstands (R1) einer elektrischen oder elektronischen Komponente (HE) in ersten Betriebsbedingungen;
- Vergleichen des bestimmten oder geschätzten ersten Erdungs- (GND) - widerstands (R1) mit einem ersten vorbestimmten Widerstandsgrenzwert (THR1), um auf einen Defekt der elektrischen oder elektronischen Komponente (HE) hin zu überprüfen,
**dadurch gekennzeichnet, dass** das Verfahren weiter die Schritte umfasst:
- Kreieren eines temporären elektrischen Leitungspfads (R_{Wasser}) durch Wasser;
- Bestimmen oder Schätzen eines zweiten Erdungs- (GND) -widerstands (R2) der elektrischen oder elektronischen Komponente, wenn solcher temporärer elektrischer Leitungspfad (R_{Wasser}) durch Wasser in den ersten Betriebsbedingungen kreiert worden ist;
- Vergleichen des bestimmten oder geschätzten zweiten Erdungs- (GND) - widerstands (R2) mit einem zweiten vorbestimmten Widerstandsgrenzwert (THR2), um auf einen Defekt der elektrischen oder elektronischen Komponente (HE) hin zu überprüfen, wenn eine elektrische Verbindung zur Erde oder zur Erdung (GND) fehlt oder sich verschlechtert.

2. Verfahren nach Anspruch 1, weiter umfassend die Schritte des:
- Umschaltens der elektrischen oder elektronischen Komponente (HE) von den ersten Betriebsbedingungen zu zweiten Betriebsbedingungen;
- Bestimmens oder Schätzens eines dritten Erdungs- (GND) -widerstands (R3) der elektrischen oder elektronischen Komponente (HE) in der zweiten Betriebsbedingung;
- Vergleichens des bestimmten oder geschätzten dritten Erdungs- (GND) - widerstands (R3) mit einem dritten vorbestimmten Widerstandsgrenzwert (THR3), um zu bemessen, ob es eine fehlende oder verschlechterte elektrische Verbindung zu der Erde oder zu der Erdung (GND) der wasserbetriebenen Vorrichtung gibt.

3. Verfahren nach Anspruch 1 oder 2, in dem die Schritte des Bestimmens oder Schätzens des ersten Erdungs- (GND) -widerstands (R1), des zweiten Erdungs-(GND) -widerstands (R2) oder des dritten Erdungs- (GND) -widerstands (R3) der elektrischen oder elektronischen Komponente (HE) weiter den Schritt des Abtastens von einem oder mehreren Spannungs-/Stromstärke-Signalen von der elektrischen oder elektronischen Komponente und den Schritt des Verarbeitens des einen oder der mehreren Spannungs-/Stromstärke-abgetasteten Signale umfasst, um einen Isolationswiderstand (Rg) der elektrischen oder elektronischen Komponente (HE) zu bestimmen oder zu schätzen.

4. Verfahren nach einem der vorstehenden Ansprüche, in dem die elektrische oder elektronische Komponente (HE) elektrisch mittels Schließens eines oder mehrerer Schalterkontakte (SW1, SW2) mittels eines Logikschaltkreises (LC) und/oder eines Steuerschaltkreises versorgt wird, bevor mindestens einer des ersten, zweiten oder dritten Erdungs- (GND) -widerstands (R3) der elektrischen oder elektronischen Komponente (HE) bestimmt oder geschätzt wird.

5. Verfahren nach einem der vorstehenden Ansprüche, in dem die elektrische oder elektronische Komponente (HE) mittels des Logikschaltkreises (LC) gesteuert wird, um elektrisch versorgt zu werden, bevor und/oder während Ausführens des Abtastens.

6. Verfahren nach einem der vorstehenden Ansprüche, in dem der erste vorbestimmte Widerstandsgrenzwert (THR1) in einem Bereich von Werten ist, für die der Isolationswiderstand der elektrischen oder elektronischen Komponente (HE) als außerhalb seiner Betriebsspezifikation angesehen werden kann, wobei der Isolationswiderstand vorzugsweise in dem Bereich von 1 Ohm bis 10 GOhm, optimal in dem Bereich von ungefähr 30 kOhm bis zu mehr als 10 MOhm und noch bevorzugter um die 70 kOhm ist.

7. Verfahren nach einem der vorstehenden Ansprüche, in dem der zweite vorbestimmte Widerstandsgrenzwert THR2 einen Widerstandspfad über Wasser (R_{Wasser}) mit einbezieht und in einem Bereich von Werten von 1 Ohm bis zu 10 GOhm, optimal in dem Bereich von 2 MOhm bis 20 MOhm, und bevorzugt um die 5 MOhm ist.

8. Verfahren nach einem der vorstehenden Ansprüche, in dem der dritte vorbestimmte Widerstandsgrenzwert THR3 optimal in dem Bereich zwischen 100 kOhm und 1 MOhm, bevorzugt um die 300 kOhm ist.

9. Verfahren nach einem der vorstehenden Ansprüche, wobei die ersten Betriebsbedingungen und die zweiten Betriebsbedingungen der elektrischen oder elektronischen Komponente (HE) derartig definiert sind, dass Isolationseigenschaften der elektrischen oder elektronischen Komponente, insbesondere eines Isolationswiderstands (Rg) davon, im Wesentlichen unterschiedlich sind.

10. Verfahren nach einem der vorstehenden Ansprüche, wobei eine erste Betriebstemperatur der elektrischen oder elektronischen Komponente (HE) in den ersten Betriebsbedingungen im Wesentlichen unterschiedlich von einer zweiten Betriebstemperatur der elektrischen oder elektronischen Komponente (HE) in den zweiten Betriebsbedingungen ist.

11. Verfahren nach einem der vorstehenden Ansprüche, wobei das Umschalten der elektrischen oder elektronischen Komponente (HE) von den ersten Betriebsbedingungen zu den zweiten Betriebsbedingungen durch einen Energetisierungsschritt der elektrischen oder elektronischen Komponente (HE) erhalten wird.

12. Verfahren nach Anspruch 10, wobei die erste Betriebstemperatur der elektrischen oder elektronischen Komponente (HE) in der ersten Betriebsbedingung geringer als die zweite Betriebstemperatur der elektrischen oder elektronischen Komponente (HE) in den zweiten Betriebsbedingungen ist.

13. Verfahren nach einem der vorstehenden Ansprüche, wobei der temporäre Widerstandspfad (R_{Wasser}) mittels eines Wasserstroms (WP) in die Vorrichtung oder mittels Entwässerns von Wasser aus der Vorrichtung kreiert wird, vorzugsweise durch automatische Betätigung eines hydraulischen Ventils und/oder durch die Betätigung einer Pumpe.

14. Verfahren nach einem der vorstehenden Ansprüche, wobei, wenn ein Fehler detektiert wird, die Vorrichtung den Fehler an einen Benutzer mit einem visuellen und/oder mit einem akustischen Signal meldet.

15. Vorrichtung, die mit Wasser betrieben wird,
vorzugsweise eine Haushaltsvorrichtung, die mit Wasser betrieben wird, ausgestattet mit:
einem Logikschaltkreis (LC) und/oder mit einem Steuerschaltkreis für die Detektion eines Fehlers, einer elektrischen oder elektronischen Komponente (HE), die in einen elektrischen Leitungspfad zur Erdung (GND) und/oder zur Erde eintreten kann aufgrund der Gegenwart von Wasser in der Vorrichtung,
**dadurch gekennzeichnet, dass** die Vorrichtung eingerichtet ist, um ein Verfahren nach einem der vorstehenden Ansprüche zu implementieren.

## Revendications

1. Procédé de détection d'un défaut dans un appareil installé opérant à l'eau, de préférence une machine à laver ou un lave-vaisselle, comprenant les étapes consistant à :
- déterminer ou estimer une première résistance (R1) à la masse (GND) d'un composant électrique ou électronique (HE) dans des premières conditions opératoires ;
- comparer la première résistance déterminée ou estimée (R1) à la masse (GND) à un premier seuil de résistance prédéterminé (THR1) afin de contrôler un défaut du composant électrique ou électronique (HE),
**caractérisé en ce que** le procédé comprend en outre les étapes consistant à :
- créer un trajet électroconducteur temporaire (Rₑₐᵤ) à travers l'eau ;
- déterminer ou estimer une deuxième résistance (R2) à la masse (GND) dudit composant électrique ou électronique lorsque ce trajet électroconducteur temporaire (Rₑₐᵤ) à travers l'eau a été créé dans lesdites premières conditions opératoires ;
- comparer ladite deuxième résistance déterminée ou estimée (R2) à la masse (GND) à un deuxième seuil de résistance prédéterminé (THR2) afin de contrôler un défaut du composant électrique ou électronique (HE) lorsqu'une connexion électrique avec la terre ou la masse (GND) est manquante ou détériorée.

2. Procédé selon la revendication 1, comprenant en outre les étapes consistant à :
- commuter ledit composant électrique ou électronique (HE) desdites premières conditions opératoires aux deuxièmes conditions opératoires ;
- déterminer ou estimer une troisième résistance (R3) à la masse (GND) dudit composant électrique ou électronique (HE) dans lesdites deuxièmes conditions opératoires ;
- comparer ladite troisième résistance déterminée ou estimée (R3) à la masse (GND) à un troisième seuil de résistance prédéterminé (THR3) afin d'évaluer s'il y a une connexion électrique manquante ou détériorée avec la terre ou la masse (GND) de l'appareil opérant à l'eau.

3. Procédé selon la revendication 1 ou 2, dans lequel les étapes de détermination ou d'estimation de ladite première résistance (R1) à la masse (GND), de ladite deuxième résistance (R2) à la masse (GND) ou de ladite troisième résistance (R3) à la masse (GND) dudit composant électrique ou électronique (HE), comprennent en outre l'étape d'échantillonnage d'un ou plusieurs signaux de tension/courant venant dudit composant électrique ou électronique et l'étape de traitement desdits un ou plusieurs signaux échantillonnés de tension/courant afin de déterminer ou estimer une résistance à l'isolement (Rg) dudit composant électrique ou électronique (HE).

4. Procédé selon l'une quelconque des revendications précédentes, dans lequel ledit composant électrique ou électronique (HE) est fourni électriquement en fermant un ou plusieurs contacts de commutation (SW1, SW2) par un circuit logique (LC) et/ou un circuit de commande avant de déterminer ou d'estimer au moins l'une de ladite première, de ladite deuxième ou de ladite troisième résistance (R3) à la masse (GND) dudit composant électrique ou électronique (HE).

5. Procédé selon l'une quelconque des revendications précédentes, dans lequel ledit composant électrique ou électronique (HE) est commandé par le circuit logique (LC) afin qu'il soit alimenté électriquement avant et/ou pendant l'exécution de l'échantillonnage.

6. Procédé selon l'une quelconque des revendications précédentes, dans lequel ledit premier seuil de résistance prédéterminé (THR1) se situe dans une plage de valeurs pour laquelle la résistance d'isolement du composant électrique ou électronique (HE) peut être considérée comme hors de sa spécification opérationnelle, ladite résistance d'isolement se situant de préférence dans la plage de 1 Ohm à 10 GOhm, de manière optimale dans la plage d'environ 30 kOhm, jusqu'à plus de 10 MOhm et, mieux encore, autour de 70 kOhm.

7. Procédé selon l'une quelconque des revendications précédentes, dans lequel ledit deuxième seuil de résistance prédéterminé (THR2) tient compte d'un trajet résistif via l'eau (Rₑₐᵤ) et se situe dans une plage de valeurs de 1 Ohm à 10 GOhm, de manière optimale dans la plage de 2 MOhm à 20 MOhm, et, de préférence, aux environs de 5 MOhm.

8. Procédé selon l'une quelconque des revendications précédentes, dans lequel ledit troisième seuil de résistance prédéterminé (THR3) se situe de manière optimale dans la plage comprise entre 100 kOhm et 1 MOhm, de préférence aux environs de 300 kOhm.

9. Procédé selon l'une quelconque des revendications précédentes, dans lequel lesdites premières conditions opératoires et lesdites deuxièmes conditions opératoires dudit composant électrique ou électronique (HE) sont définies de manière à ce que les propriétés isolantes dudit composant électrique ou électronique, en particulier une résistance d'isolement (Rg) de celui-ci, soient sensiblement différentes.

10. Procédé selon l'une quelconque des revendications précédentes, dans lequel une première température opératoire dudit composant électrique ou électronique (HE) dans lesdites premières conditions opératoires est sensiblement différente d'une deuxième température opératoire dudit composant électrique ou électronique (HE) dans lesdites deuxièmes conditions opératoires.

11. Procédé selon l'une quelconque des revendications précédentes, dans lequel ladite commutation dudit composant électrique ou électronique (HE) desdites premières conditions opératoires auxdites deuxièmes conditions opératoires est obtenue par une étape d'excitation dudit composant électrique ou électronique (HE).

12. Procédé selon la revendication 10, dans lequel ladite première température opératoire dudit composant électrique ou électronique (HE) dans lesdites premières conditions opératoires est inférieure à ladite deuxième température opératoire dudit composant électrique ou électronique (HE) dans lesdites deuxièmes conditions opératoires.

13. Procédé selon l'une quelconque des revendications précédentes, dans lequel ledit trajet résistif temporaire (Rₑₐᵤ) est créé en faisant couler un courant d'eau (WP) dans ledit appareil ou en drainant l'eau dudit appareil, de préférence par actionnement automatique d'une vanne hydraulique et/ou par actionnement d'une pompe.

14. Procédé selon l'une quelconque des revendications précédentes, dans lequel, lorsqu'un défaut est détecté, l'appareil notifie ledit défaut à un utilisateur par un signal visuel et/ou un signal acoustique.

15. Appareil opérant à l'eau, de préférence appareil domestique opérant à l'eau, pourvu d'un circuit logique (LC) et/ou d'un circuit de commande pour la détection d'un défaut, un composant électrique ou électronique (HE) qui peut entrer dans un trajet conducteur de l'électricité à la masse (GND) et/ou à la terre en présence d'eau dans l'appareil, **caractérisé en ce que** l'appareil est configuré pour mettre en oeuvre un procédé selon l'une quelconque des revendications précédentes.
